(19)

**Europäisches Patentamt**
**European Patent Office**
**Office européen des brevets**

(11) **EP 1 962 428 A1**

(12) **EUROPEAN PATENT APPLICATION**

(43) Date of publication:
 **27.08.2008 Bulletin 2008/35**

(51) Int Cl.:
 **H03M 1/42** (2006.01)

(21) Application number: **08002687.5**

(22) Date of filing: **13.02.2008**

(84) Designated Contracting States:
 **AT BE BG CH CY CZ DE DK EE ES FI FR GB GR HR HU IE IS IT LI LT LU LV MC MT NL NO PL PT RO SE SI SK TR**
 Designated Extension States:
 **AL BA MK RS**

(30) Priority: **13.02.2007 KR 20070015051**

(71) Applicant: **Samsung Electronics Co., Ltd.**
 **Suwon-si, Gyeonggi-Do (KR)**

(72) Inventors:
 • **Maskou, Dzmitry**
 **Suwon-si**
 **Gyeonggi-do (KR)**
 • **Park, Bok-Ju**
 **Suwon-si**
 **Gyeonggi-do (KR)**

(74) Representative: **Lang, Johannes**
 **Bardehle Pagenberg Dost Altenburg Geissler,**
 **Postfach 86 06 20**
 **81633 München (DE)**

(54) **Method and apparatus for analog-to-digital conversion using switched capacitors**

(57) A method and apparatus are provided for analog-to-digital conversion, which uses switched capacitors for quantizing an input current. The apparatus for analog-to-digital conversion includes a plurality of charge units configured for being input with a current signal in an analog form, being sequentially charged with the input current signal, and providing a high-level or low-level signal to each next sequentially connected charge unit according to whether or not the charged charge unit is charged above a predetermined threshold value. The apparatus also includes a latch register for receiving the high-level or low-level signals output from the plurality of charge units, converting the received high-level or low-level signals into a linear code, and outputting the converted linear code. The high-level signal is used for starting to charge the next connected charge unit.

FIG.1

EP 1 962 428 A1

**Description**

**BACKGROUND OF THE INVENTION**

1. Field of the Invention

The present invention relates generally to analog-to-digital conversion, and more particularly, to an Analog-to-Digital Converter (ADC) using switched capacitors for quantizing an input current, and a method for analog-to-digital conversion corresponding to such an ADC.

2. Description of the Related Art

Digital signal processing has been widely used throughout the industry in various application fields. Digital signal processing typically operates on a digital signal obtained from an analog signal. The conversion of an analog signal into a digital signal is often performed by an ADC.

An ADC refers to an apparatus that is input with an analog signal in the form of a continuously varying physical quantity, and converts the input analog signal into a digital signal in the form of a discretely varying physical quantity. The types of ADCs include a parallel comparator type ADC, a flash ADC, a pipelined ADC, an algorithmic ADC, a successive approximation ADC, and so forth.

In the parallel comparator type ADC, an analog input voltage is applied to a plurality of comparators, the number of which is $2^n$-1. Here, "n" is the number of digital bits to be generated. Different reference voltages in a range from the highest expected voltage to the lowest expected voltage are applied to the respective comparators. Also, outputs of the respective comparators are logically synthesized to thereby generate n digital bits.

Analog-to-digital conversion is an electronic process of continuously converting an analog signal into a multi level discretely varying digital signal without changing essential contents, and the ADC converts an analog signal into a signal that has discrete levels or states, that is, a digital signal.

The discrete states are represented by a combination of one or more binary digits (bits). The number of the states is always equal to a power of 2, including 2, 4, 8, 16, etc. The simplest digital signal has only two states (either "0" or "1") that are called a binary signal.

In various aspects, digital signals are generally more suitable for signal processing in most communication applications than analog signals, which results from the following two factors.

First, digital signals have a high error margin as compared to analog signals. Digital signals are in the form of well-defined orderly digital impulses. Moreover, most electronic circuits easily discern digital signals from noise.

Secondly, while a considerable number of error detection and correction schemes have evolved toward digital signals, there is substantially no error detection and correction scheme for analog signals. Moreover, the most recent technologies in communication applications convert analog data into digital data for the purpose of data transmission.

In addition, all computers perform processing in the format of binary digital signals. These computers also use a plurality of applications requiring interactions with analog interfaces.

Some examples of such applications include voice processing, digital signal processing, modems, and the like.

In order to handle these applications, computers must convert analog signals into digital signals. The use of computers for handling these applications has increased the necessity of analog-to-digital conversion.

If an input signal is of analog form, an ADC is generally required in all digital signal processing systems. Some examples of ADC-based applications include phone modems, xDSL (x Digital Subscribe Line) modems, and cellular phones. Typical phone modems use an ADC to transform audio, input from a twisted pair line, into a computer-processable form.

Many ADC architectures are well known. Different ADC architectures provide different gains in conversion speed, conversion resolution, implementation cost (or complexity), power consumption, etc.

In a typical ADC architecture called a flash ADC, an input signal is compared to a reference voltage, and a result of the comparison is decoded into a digital signal. The flash ADC architecture converts an analog signal into a digital signal by using a series of comparators with different threshold voltages.

The flash ADC architecture uses the fastest ADC technology. However, a number of comparators (2.sup.*N* comparators) are required to implement a flash ADC. Here, "*N*" is the number of bits of resolution. The resolution of an ADC may be defined by the number of bits, each of which is representative of each sample of a digital signal corresponding to an analog signal. As a result of using 2.sup.N comparators for *N*-bit resolution, the number of comparators exponentially increases with an increase in resolution. Thus, power consumption also exponentially increases with an increase in resolution. Moreover, flash ADCs have a drawback in that high power consumption and cost are required for their circuit implementations. Although many architectures are proposed for improving flash ADCs, most of them are limited to 8-bit resolution so as to provide appropriate performance.

A well-known ADC architecture other than the above-mentioned flash ADC architecture is a pipelined ADC.

Pipelined ADCs are performed together using cascaded multiple stages. Each of the multiple stages is performed using a 2-step flash ADC. Pipelined ADCs are implemented with a lower cost than flash ADCs. Also, pipelined ADCs exhibit less complexity than flash ADCs while providing similar resolution to flash ADCs. Further, pipelined ADCs have lower power drain than flash ADCs. However, pipelined ADCs cause a considerable delay between an analog sample of an analog signal and a digital value representative of the analog sample. The delay interval depends on the number of pipelined stages. Another drawback of pipelined ADCs is that conversion speed decreases with an increase in conversion resolution.

In the pipelined ADC architecture, conversion speed decreases as input stages increase so as to provide more accurate processing for an input signal, which results from the setting time of an amplifier. To address such a drawback, time interleaving technology for multiple pipelined ADCs has been proposed.

However, the time interleaving technology is restricted by sampling intervals related to other stages, relative gain and offset match, and the accuracy of timing jitter of sampling clocks.

Another type of ADC architecture is a successive approximation ADC. The successive approximation ADC considers high resolution. However, the successive approximation ADC has low speed because it typically requires $N$ cycles for performing analog-to-digital conversion with $N$-bit resolution.

Therefore, a high-speed ADC architecture is employed in a folding ADC.

Folding ADC technology is used for implementing high-speed ADC technology. Here, the folding ADC technology refers to technology for generating a folded signal, that is, technology for replicating an input signal using a plurality of folding amplifiers.

A digital output signal is produced by detecting a zero crossing of the folding amplifiers. Although folding ADCs are faster than successive approximation ADCs, the folding technology requires many amplifiers for implementing high resolution. This results in relatively high power consumption. Also, the main disadvantage of the folding ADC is that a bandwidth is reduced due to the internal multiplication of an input signal frequency considered by a folding rate.

The number of folding amplifiers may be reduced using interpolation, but the interpolation used as folding restricts the dynamic range of an ADC.

Another famous type of ADC architecture is a sigma-delta ADC. The sigma-delta ADC allows higher resolution (10 to 24 bits). However, such an ADC is relatively slow because requisite level resolution is performed by oversampling of an input signal and noise shaping.

Further, the performance of the sigma-delta ADC is affected directly by an oversampling rate used by the ADC. A sigma-delta ADC used for an advanced wideband application is largely divided into two types, that is, a multi-bit sigma-delta ADC and a continuous time sigma-delta ADC.

The multi-bit sigma-delta ADC does not require a high sampling rate, but has high power dissipation (about 40 to 50 mWin W-CDMA). Contrarily, the continuous time sigma-delta ADC is low in analog power dissipation (less than 5 mW), but has a high sampling frequency (300 Mhz), which causes an increase in power dissipation.

Thereupon, there is a need for an ADC that provides high conversion resolution and does not require a high oversampling rate. Additionally, there is a need for an ADC with low power dissipation.

Further, an ADC with less hardware complexity and cost for implementation is needed. Power consumption and implementation cost are very important elements of ADC applications. As described above, ADC technology is a requisite and an important technology in signal processing in communication systems.

## SUMMARY OF THE INVENTION

The present invention has been made to address at least the above problems and/or disadvantages and to provide at least the advantages described below. Accordingly, an aspect of the present invention provides a method and apparatus for analog-to-digital conversion, which has low power consumption and is easy to implement in a CMOS process.

According to one aspect of the present invention, an apparatus is provided for analog-to-digital conversion. The apparatus includes a plurality of charge units configured for being input with a current signal in an analog form, being sequentially charged with the input current signal, and providing a high-level or low-level signal to each next sequentially connected charge unit according to whether or not the corresponding charged charge unit is charged above a predetermined threshold value. The apparatus also includes a latch register for receiving the high-level or low-level signals output from the plurality of charge units, converting the received high-level or low-level signals into a linear code, and outputting the converted linear code. Preferably, the high-level signal is used for starting to charge each charge unit connected next to each charged charge unit.

According to another aspect of the present invention, a method for analog-to-digital conversion is provided. A plurality of charge units are sequentially charged with an input current signal in an analog form. A high-level or low-level signal is provided to each charge unit connected next to each charged charge unit according to whether or not the corresponding charged charge unit is charged above a predetermined threshold value. The high-level or low-level signals output from the plurality of charge units are received, the received high-level or low-level signals are converted into a linear code, and the converted linear code is output. Preferably, the high-level signal is used for starting to charge each charge unit connected next to each charged charge unit.

**BRIEF DESCRIPTION OF THE DRAWINGS**

The above and other aspects, features and advantages of the present invention will be more apparent from the following detailed description when taken in conjunction with the accompanying drawings, in which:

FIG 1 is a block diagram illustrating a structure of an ADC in accordance with a first embodiment of the present invention;
FIG 2 is a block diagram illustrating a structure of an ADC in accordance with a second embodiment of the present invention;
FIG 3 is a timing chart of an analog-to-digital conversion operation in accordance with an embodiment of the present invention; and
FIG 4 is a view illustrating an example of implementing capacitor lines connected with parallel switches by using a CMOS process in accordance with an embodiment of the present invention.

**DETAILED DESCRIPTION OF THE PREFERRED EMBODIMENTS**

Preferred embodiments of the present invention are described in detail with reference to the accompanying drawings. In the following description, the same or similar elements are designated by the same reference numerals although they are shown in different drawings. Detailed descriptions of constructions or processes known in the art may be omitted to avoid obscuring subject matter of the present invention.

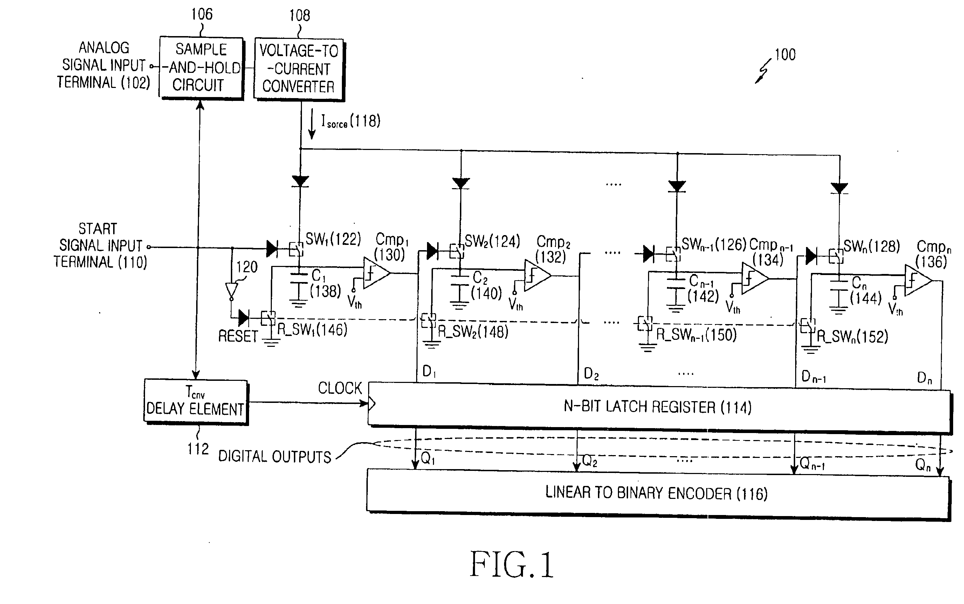

FIG. 1 illustrates the structure of an ADC 100 according to a first embodiment of the present invention.

The ADC 100 according to the first embodiment of the present invention includes: an analog signal input terminal 102; a start signal input terminal 110; a sample-and-hold circuit 106 for being input with an analog signal through the analog signal input terminal 102 and sampling/holding the input analog signal; a voltage-to-current converter 108 for converting a voltage into a current; a plurality of capacitors $C_1$ to $C_n$ 138, 140, 142, 144 for being charged with electric charges corresponding to the amount of current output from the voltage-to-current converter 108; a plurality of switches $SW_1$ to $SW_n$ 122, 124, 126, 128 for preventing the capacitors $C_1$ to $C_n$ 138, 140, 142, 144 from being simultaneously charged; a plurality of reset switches $R\_SW_1$ to $R\_SW_n$ 146, 148, 150, 152 for discharging voltages charged in the capacitors $C_1$ to $C_n$ 138, 140, 142, 144; a plurality of comparators $Cmp_1$ to $Cmp_n$ 130, 132, 134, 136; a delay element 112 for outputting a start signal, input through the start signal input terminal 110, with a delay time corresponding to a conversion time $T_{cnv}$; an inverter 120; an $n$-bit latch register 114 for storing output values $D_1$ to $D_n$ from the plurality of comparators 130, 132, 134, 136; and a plurality of output terminals $Q_1$ to $Q_n$ for outputting bits stored in the $n$-bit latch register 114.

A sample of the analog signal input through the analog signal input terminal 102 is obtained from the rising edge of the start signal input through the start signal input terminal 110 using the sample-and-hold circuit 106. The voltage-to-current converter 108 supplies a constant current in proportion to a voltage maintained by the sample-and-hold circuit 106.

The implementation of the sample-and-hold circuit 106 and the voltage-to-current converter 108 is well known in the art. Also, in the present invention, it is assumed that any delay due to the sample-and-hold circuit 106 and the voltage-to-current converter 108 is negligible.

The delay element 112 is used for generating an internal clock corresponding to a replica of the start signal, which is delayed by the conversion time $T_{cnv}$. That is, the delay element 112 delays the start signal by $T_{cnv}$ to thereby generate a clock signal for allowing the $n$-bit latch register 114 to store the output values $D_1$ to $D_n$ from the plurality of comparators 130, 132, 134, 136. Logical signals output from the comparators 130, 132, 134, 136, that is, $D_1$ to $D_n$, are latched in the $n$-bit latch register 114 by the rising edge of the clock signal generated in the delay element 112. The conversion time is a time taken to convert the analog signal into a digital signal.

In other words, the delay element 112 delays the start signal until the capacitors $C_1$ to $C_n$ 138, 140, 142, 144 are charged with electric charges corresponding to the amount of current of the analog signal, and the output values from the comparators 130, 132, 134, 136 are stored in the latch.

The inverter 120 is used to generate an internal reset signal for resetting the capacitors 138, 140, 142, 144 from the signal input through the start signal input terminal 110. That is, the inverter 120 generates a reset signal for operating the reset switches 146, 148, 150, 152 to thereby discharge all the capacitors that have been charged before a new start signal is input. When the start signal is changed to "low", the reset signal is in an active state (at a high-logic level) by the inverter 120, which turns on the reset switches $R\_SW_1$ to $R\_SW_n$ 146, 148, 150, 152 to thereby discharge the capacitors 138, 140, 142, 144 through the reset switches $R\_SW_1$ to $R\_SW_n$ 146, 148, 150, 152.

Although the internal clock and reset signals generated in the delay element 112 and the inverter 120 respectively are described as originating form the start signal in this embodiment of the present invention, they may also be generated by any other element or from an external signal.

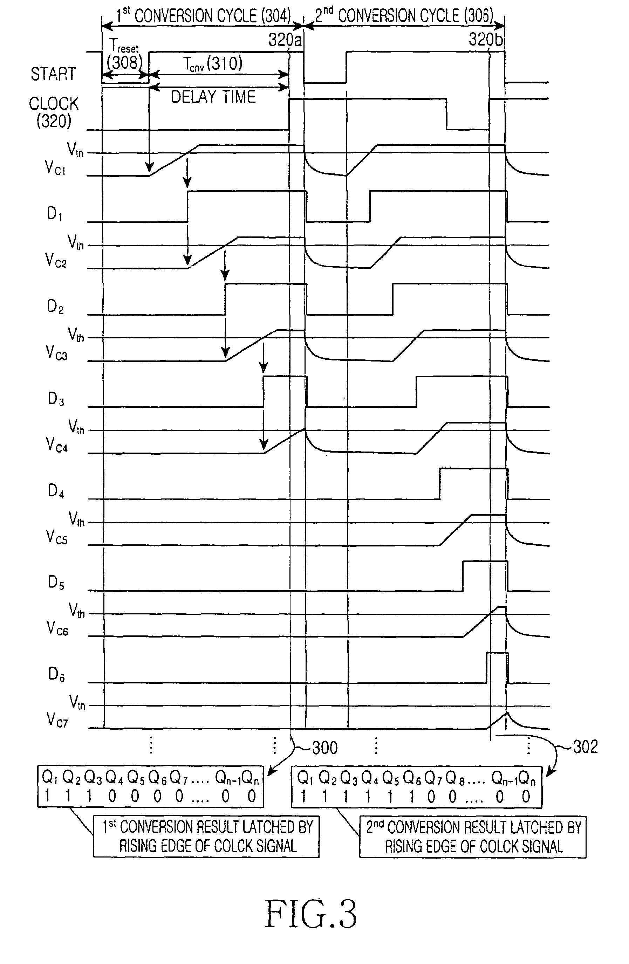

The delay element 112 and the inverter 120 will be described in detail below with reference to a timing chart of FIG 3.

The principle of analog-to-digital conversion according to the present invention is based on a sequential charging series of capacitors $C_1$ to $C_n$ 138, 140, 142, 144 with the same capacitance value, which are sequentially charged with a constant current. The switches $SW_1$ to $SW_n$ prevent the capacitors $C_1$ to $C_n$ from being simultaneously charged. During the time when the charged voltage of a previous capacitor is less than a threshold voltage $V_{th}$ of each comparator $Cmp_1$ to $Cmp_n$, a capacitor charging process for a next capacitor is not started. In the present invention, it does not matter if a next capacitor starts charging while a previous capacitor completes its charging process.

If each capacitor can store electric charges, the quantity of which is $q_{cap}$, when being charged with a maximum voltage $V_{cap}$, then the total quantity of electric charges, $Q_{total}$, stored from a current source $I_{source}$ 118 that is output from the voltage-to-current converter 108 during the conversion time $T_{cnv}$ can be calculated by Equation (1):

$$Q_{total} = I_{source} * T_{cnv} \text{ ------------------------------------------------------ (1)}$$

Also, if the number of capacitors fully charged during the conversion time $T_{cnv}$ is N, $Q_{total}$ can be calculated by Equation (2):

$$Q_{total} = q_{cap} * N \text{ ------------------------------------------------------ (2)}$$

Further, N, that is, the number of capacitors fully charged during the conversion time $T_{cnv}$, can be calculated by Equation (3) derived from Equations (1) and (2):

$$N = I_{source} * T_{cnv} / q_{cap} \text{ ------------------------------------------------------ (3)}$$

In addition, the number of fully charged capacitors is proportional to the current source $I_{source}$. The number of fully charged capacitors is stored in the output latch, that is, the n-bit latch register 114, in a linear form corresponding to a result of the conversion. A result of the conversion represents the magnitude of a digitized signal. That is, it represents a digital value according to how many capacitors are charged. For example, if three capacitors are charged, a result of the conversion has a linear code value of "111", which is equivalent to binary "11". Of course, if eight capacitors are charged, a result of the conversion has a linear code value of "11111111" equivalent to binary "100".

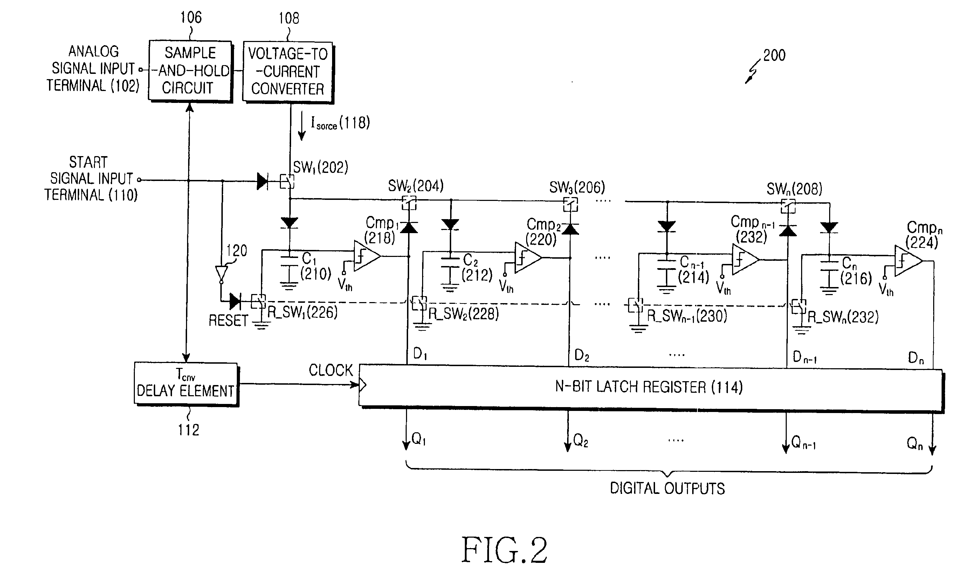

FIG 2 illustrates the structure of an ADC according to a second embodiment of the present invention. In FIG 2, the same reference numerals are used to designate the same elements as in FIG. 1, so a detailed description thereof will be omitted. A difference between FIG 1 and FIG. 2 is whether the switches $SW_1$ to $SW_n$ for preventing the capacitors $C_1$ to $C_n$ from being simultaneously charged are connected in series or parallel with the current source $I_{source}$. That is, while the switches are connected in parallel with the current source in FIG 1, the switches are connected in series with the current source in FIG. 2. The technical problem of the present invention may be solved through both the structures of FIGS. 1 and 2, but a more accurate result can be obtained through the structure of FIG 1 where the switches are connected in parallel with the current source, rather than that of FIG 2.

In the first embodiment, all the switches $SW_1$ to $SW_n$ have a common connection point (i.e., all the switches $SW_1$ to $SW_n$ are connected with the voltage-to-current converter 108 at any one point). However, in the second embodiment, the switches $SW_1$ to $SW_n$ have no common connection point (i.e., the end point of one switch is connected with the beginning point of a next switch).

In the first embodiment, the current from the voltage-to-current converter 108 has only to pass through a single switch for each capacitor when the corresponding capacitor is charged. Contrarily, in the second embodiment, the current must pass through N switches until it reaches the nth capacitor.

Assuming that each of the switches is an ideal switch with a resistance of 0 ohm, the first and second embodiments of the present invention have no difference in functionality. However, if the switches are transistors that are

EP 1 962 428 A1

actually manufactured in a CMOS process, they probably have a small resistance value. When a current "$I$" passes through a resistance "$R$", a voltage drop of "$V = I*R$" occurs. Thus, the same voltage drop occurs for all the capacitors in the first embodiment, but different voltage drops occur for the respective capacitors in the second embodiment. This means that the respective capacitors in the second embodiment are charged with different levels of voltage and different quantity of electric charges. However, the main principle of analog-to-digital conversion (more exactly analog-to-linear code conversion) according to the present invention requires all the capacitors to be charged with the same quantity of electric charges. Therefore, when the present invention is implemented using transistors, the first embodiment is advantageous over the second embodiment.

Hereinafter, a more detailed description will be given of a procedure where the capacitors $C_1$ to $C_n$ are charged by the current source $I_{source}$ 118, and the number of the charged capacitors is stored in the $n$-bit latch register 114 in FIG 1.

First, since the inverter 120 is at a high level before any start signal is input through the start signal input terminal 110, it turns on all the reset switches $R\_SW_1$ to $R\_SW_n$, thereby discharging all the capacitors. Then, a start signal is input through the start signal input terminal 110, and the sample-and-hold circuit 106 outputs an analog signal, input through the analog signal input terminal 102, to the voltage-to-current converter 108, which in turn outputs a converted current $I_{souree}$. The start signal input through the start signal input terminal 110 is applied to the switch $SW_1$ 122 to thereby turn on the switch $SW_1$ 122, and the delay element 112 delays the start signal by the conversion time $T_{cnv}$ and then generates a clock for operating the $n$-bit latch register 114 to store a value (linear code value) output from the comparator. Also, if the start signal is input through the start signal input terminal 110, the inverter 120 outputs a low-level signal, and thus the reset switches R_SW$_1$ to R_SW$_n$ 146, 148, 150, 152 are all turned off.

If the capacitor $C_1$ 138 is fully charged after the switch $SW_1$ 122 is turned on, the comparator $Cmp_1$ 130 compares the magnitude of a voltage charged in the capacitor $C_1$ 138 with a predetermined threshold value $V_{th}$. When a result of the comparison shows that the voltage charged in the capacitor $C_1$ 138 exceeds the threshold value $V_{th}$, the comparator $Cmp_1$ 130 outputs a high-level signal ("1") to thereby output "1" as $D_1$, and simultaneously turns on the switch $SW_2$ 124 to thereby charge the capacitor $C_2$ 140.

Once the capacitor $C_2$ 140 is charged, the comparator $Cmp_2$ 132 compares the magnitude of a voltage charged in the capacitor $C_2$ 140 with the threshold value $V_{th}$. When a result of the comparison shows that the voltage charged in the capacitor $C_2$ 140 is greater than $V_{th}$, the comparator $Cmp_2$ 132 outputs a high-level signal, that is, "1". However, when a result of the comparison shows that the voltage charged in the capacitor $C_2$ 140 is equal to or less than $V_{th}$, the comparator $C_{mp2}$ 132 outputs a low-level signal, that is, "0". If the voltage charged in the capacitor $C_2$ 140 is greater than $V_{th}$, the same procedure as described above is repeated. When the comparator $C_{mp2}$ 132 outputs "0", the switch $SW_3$ (not illustrated) is not turned on, and thus all the capacitors following the capacitor $C_2$ 140 are not charged. This means that all the comparators following the comparator $Cmp_2$ 132 output "0". The above-mentioned operation is repeatedly performed for the remaining switches and comparators up to $SW_n$ 128 and $Cmp_n$ 136.

After the final comparator $Cmp_n$ 136 completes the above-mentioned operation, the $n$-bit latch register 114 stores the output values $D_1$ to $D_n$ from the comparators. The $n$-bit latch register 114 stores the output values $D_1$ to $D_n$ at a point of time when the clock generated by the delay element 112 reaches a rising edge.

The delay element 112 generates a clock signal, necessary for storing the output values $D_1$ to $D_n$, from the start signal input through the start signal input terminal 110, and a delay time for generating the clock signal by delaying the start signal may be determined by the ADC conversion time $T_{cnv}$.

In the embodiments of the present invention, $T_{cnv}$ may be set to different values according to designers of ADC circuits. For example, if a maximum current processable by an ADC circuit is predefined, and a relation between charging and a current, the inherent capacitance of each capacitor, etc, are known, the number of fully chargeable capacitance can be known, and thus a point of time when the $n$-bit latch register 114 reads the output values $D_1$ to $D_n$ from the comparators can also be known. Additionally, in the specification, the capacitors, the switches, the reset switches, and the comparators are generally referred to as "charge units".

FIG 2 illustrates the structure of an ADC circuit according to the second embodiment of the present invention, and is different from FIG 1 in that the switches $SW_1$ to $SW_n$ are connected in series with the current source $I_{source}$, as mentioned above. That is, in FIG 2, if all the capacitors $C1$ to $C_n$ 210, 212, 214, 216 are discharged by the inverter 120 before a start signal is input through the start signal input terminal 110, and then the start signal is applied to the switch $SW_1$ 202, the switch $SW_1$, 202 is turned on, and the current source $I_{source}$ 118 output from the voltage-to-current converter 108 charges the capacitor $C_1$ 210. After the capacitor $C_1$ 210 is charged, the comparator $C_{mp1}$ 218 compares the magnitude of a voltage charged in the capacitor $C_1$ 210 with a predetermined threshold value $V_{th}$. When a result of the comparison shows that the voltage charged in the capacitor $C_1$ 210 is greater than $V_{th}$, the comparator $C_{mp1}$ 218 outputs a high-level logic value "1". If the high-level logic value "1" is output, the switch SW2 204 is turned on, and an output value $D_1$ stored in the $n$-bit latch register 114 becomes "1".

Similarly, the capacitor $C_2$ 212 is charged after the switch $SW_2$ 204 is turned on, the comparator $Cmp_2$ 220 compares the magnitude of a voltage charged in the capacitor $C_2$ 212 with $V_{th}$. When a result of the comparison shows that the voltage charged in the capacitor $C_2$ 212 is greater than $V_{th}$, the comparator $Cmp_2$ 220 outputs a high-level logic value "1". Contrarily, when the voltage charged in the capacitor $C_2$ 212 is equal to or less than $V_{th}$, the comparator $Cmp_2$ 220 outputs a low-level logic value "0". Also, an output value $D_2$ from the comparator $Cmp_2$ 220 is stored in the $n$-bit latch register 114.

The above-mentioned operation is repeatedly performed over the circuit portions covering $SW_3$ 206 to $SW_n$ 208, $C_{n-1}$ 214, $C_n$ 216, $Cmp_n$ 224, $R\_SW_{n-1}$ 230, and $R\_SW_n$ 232. This operation is performed in the same manner as described above.

Upon storing the output values $D_1$ to $D_n$ through the procedure described above, the $n$-bit latch register 114 outputs a linear code through the output terminals $Q_1$ to $Q_n$, and the output linear code is converted into a binary code by a linear-to-binary encoder 116 illustrated in FIG 1.

Examples of converting a linear code output from the $n$-bit latch register 114 into a binary code are shown below in Table 1.

Table 1

| Linear code | 000000 | 000001 | 000011 | 000111 |
|---|---|---|---|---|
| Binary code | 000000 | 000001 | 000010 | 000011 |

In FIG 2, there is a problem in that a current for charging each capacitor is supplied via a switch at each stage, which results in lower accuracy than that in FIG 1.

FIG. 3 illustrates a timing chart of an analog-to-digital conversion operation according to an embodiment of the present invention.

The timing chart of FIG. 3 shows an operational sequence in an ADC. FIG 3 may be applied to both FIGS. 1 and 2.

In FIG 3, two conversion cycles, that is, a first conversion cycle 304 and a second conversion cycle 306, are illustrated. Both the conversion cycles are started when a start signal is in a low state during a time interval $T_{reset}$ 308. The time interval $T_{reset}$ 308 is an interval during which the reset switches $R\_SW_1$ to $R\_SW_n$ are turned on so as to discharge all the capacitors of the ADC circuit 100 or 200 before the analog-to-digital conversion operation is performed. $T_{cnv}$ 310 is a time during which the start signal is input into the delay element 112 and is delayed thereby, and is predetermined by the designer of the ADC circuit.

That is, by providing the time interval $T_{reset}$ 308, all the capacitors $C_1$ to $C_n$ existing in the ADC circuit 100 or 200 are fully discharged, and outputs $D_1$ to $D_n$ of all the comparators $Cmp_1$ to $Cmp_n$ are converted into a low level. When the start signal is in a high level, the switch $SW_1$ 122 or 202 of FIG. 1 or 2 is first turned on, and then the current $I_{source}$ output from the voltage-to-current converter 108 starts to charge the capacitor $C_1$ 138 or 210 of FIG 1 or 2.

If a voltage $VC_1$ charged in the capacitor $C_1$ 138 or 210 is greater than a predetermined threshold value $V_{th}$, the comparator $Cmp_1$ 130 or 210 in FIG 1 or 2 outputs a high-level value as its output signal $D_1$. If the output signal $D_1$ has an active high-level value, the switch $SW_2$ 124 or 204 is turned on, and the input current charges the next capacitor. This operation is repeated until a clock signal reaches a rising edge, and all the output signals output so far from the comparators are stored in the $n$-bit latch register 114. The number of outputs that are output from the $n$-bit latch register 114 through the output terminals $Q_1$ to $Q_n$ represents a result of the analog-to-digital conversion.

In FIG 3, $I_{source}$ input in the first conversion cycle 304 and $I_{source}$ input in the second conversion cycle 306 have different values, and it can be noted that $I_{source}$ input in the second conversion cycle 306 has a greater value because an output value corresponding to $D_1$ to $D_n$ at the rising edge of the clock signal is presented as designated by reference numerals "300" and "302" in the first and second conversion cycles, respectively. That is, comparing the output value in the first conversion cycle 304 with the output value in the second conversion cycle 306, a linear code value in the first conversion cycle 304 is "1110000 - 00" while a linear code value in the second conversion cycle 306 is "111111 ~ 00", which means that the output value in the second conversion cycle 306 is greater than that in the first conversion cycle 304.

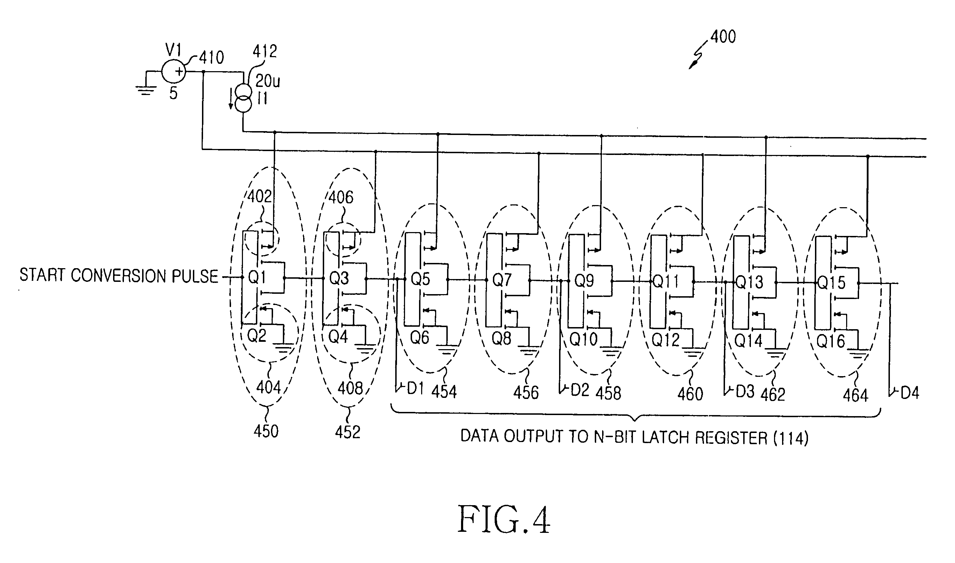

FIG. 4 illustrates an example of implementing capacitor lines connected with parallel switches by using a CMOS process according to an embodiment of the present invention.

In a chain of CMOS inverters, every even inverter 452, 456, 460, 464 is connected with a voltage source 410, and every odd inverter 450, 454, 458, 462 is connected with a current source 412.

Every odd inverter 450, 454, 458, 462 functions as a switch, and every even inverter 452, 456, 460, 464 functions as a capacitor and a comparator at the same time. More specially, in the first CMOS inverter 450, reference numeral "402" corresponds to the switch $SW_1$ 122 or 202 of FIG 1 or 2, and reference numeral "404" corresponds to the reset switch $R\_SW_1$ 146 or 226 of FIG 1 or 2. In the second CMOS inverter 452, reference numerals "406" and "408" correspond to the capacitor and the comparator of FIG 1 or 2, respectively.

As described above, an ADC according to the present invention can be simply and easily implemented in a CMOS process, and has low power consumption.

The embodiments of the present invention described above propose new ways for analog to digital conversion.

Main features of an ADC proposed include a simple architecture, easy and efficient implementation in a CMOS process, and low power consumption. A conversion rate is proportional to ADC resolution. Such an ADC is used in all applications that require low power consumption, moderate resolution, and moderate sampling rate. Examples of such applications include RF transceivers in mobile communication systems, software defined radio receivers, and digital video and image processing systems.

While the invention has been shown and described with reference to certain preferred embodiments thereof, it will be understood by those skilled in the art that various changes in form and details may be made therein without departing from the spirit and scope of the invention as defined by the appended claims.

**Claims**

1.  An apparatus for analog-to-digital conversion, the apparatus comprising:

    a plurality of charge units each configured for being input with a current signal in an analog form, being sequentially charged with the input current signal, and providing a high-level or low-level signal to a next sequentially connected charge unit according to whether or not the charged charge unit is charged above a predetermined threshold value; and
    a latch register for receiving the high-level or low-level signals output from the plurality of charge units, converting the received high-level or low-level signals into a linear code, and outputting the converted linear code.

2.  The apparatus as claimed in claim 1, wherein the high-level signal is used for starting to charge each next sequentially connected charge unit.

3.  The apparatus as claimed in claim 1, wherein each charge unit comprises:

    a capacitor;
    a switch for connecting the current signal with the capacitor if a signal for starting to charge the capacitor is input; and
    a comparator for outputting the high-level signal to the next sequentially connected charge unit as a signal, indicating to start charging the next sequentially connected charge unit, if a voltage charged in the capacitor is greater than the predetermined threshold value, and outputting the low-level signal to the next sequentially connected charge unit if the voltage charged in the capacitor is equal to or less than the threshold value.

4.  The apparatus as claimed in claim 3, wherein each charge unit further comprises a reset switch for discharging the capacitor before a start signal indicating to start the analog-to-digital conversion is input.

5.  The apparatus as claimed in claim 1, further comprising a linear-to-binary encoder for converting the linear code, output from the latch register, into a binary code.

6.  The apparatus as claimed in claim 4, further comprising a delay element for providing the latch register with a clock signal by delaying the start signal such that the latch register outputs the linear code when the charge units are charged with electric charges corresponding to the amount of current input in the analog form.

7.  A method for analog-to-digital conversion, the method comprising the steps of:

    sequentially charging a plurality of charge units with an input current signal in an analog form;
    providing a high-level or low-level signal to each next sequentially connected charge unit according to whether or not the charged charge unit is charged above a predetermined threshold value; and
    receiving the high-level or low-level signals output from the plurality of charge units, converting the received high-level or low-level signals into a linear code, and outputting the converted linear code.

8.  The method as claimed in claim 7, wherein the high-level signal is used for starting to charge each next sequentially connected charge unit.

9.  The method as claimed in claim 7, wherein the step of charging the plurality of charge units comprises charging a capacitor with the current signal.

**10.** The method as claimed in claim 9, further comprising discharging the capacitor before a start signal indicating to start the analog-to-digital conversion is input.

**11.** The method as claimed in claim 7, wherein the step of providing the high-level or low-level signal to each charge unit connected next to each charged charge unit comprises outputting the high-level signal to the next sequentially connected charge unit if a voltage charged in the capacitor is greater than the predetermined threshold value, and outputting the low-level signal to the next sequentially connected charge unit if the voltage charged in the capacitor is equal to or less than the threshold value.

**12.** The method as claimed in claim 7, further comprising converting the linear code into a binary code.

**13.** The method as claimed in claim 10, further comprising providing a clock signal by delaying the start signal such that the linear code is output when the charge units are charged with electric charges corresponding to the amount of current input in the analog form.

FIG.1

EP 1 962 428 A1

EP 1 962 428 A1

ANALOG
SIGNAL INPUT
TERMINAL (102)

106
SAMPLE
-AND-HOLD
CIRCUIT

108
VOLTAGE-TO
-CURRENT
CONVERTER

200

$I_{sorce}$(118)

START
SIGNAL INPUT
TERMINAL (110)

$SW_1$(202)

$SW_2$(204)

$SW_3$(206)

$SW_n$(208)

120

$Cmp_1$
(218)

$Cmp_2$
(220)

$Cmp_{n-1}$
(232)

$Cmp_n$
(224)

$C_1$
(210)

$C_2$
(212)

$C_{n-1}$
(214)

$C_n$
(216)

$V_{th}$

$V_{th}$

$V_{th}$

$V_{th}$

RESET

$R\_SW_1$(226)

$R\_SW_2$(228)

$R\_SW_{n-1}$(230)

$R\_SW_n$(232)

$D_1$

$D_2$

$D_{n-1}$

$D_n$

$T_{cnv}$
DELAY ELEMENT

112

CLOCK

N-BIT LATCH REGISTER (114)

$Q_1$

$Q_2$

$Q_{n-1}$

$Q_n$

DIGITAL OUTPUTS

FIG.2

FIG.3

FIG.4

**European Patent Office**

**EUROPEAN SEARCH REPORT**

Application Number

EP 08 00 2687

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 541 110 A (KAWASAKI STEEL CO [JP] KAWASAKI STEEL CO [US]) 12 May 1993 (1993-05-12) | 1-3,7-9, 11 | INV. H03M1/42 |
| X | * column 18, line 17 - line 25; figure 9 * | 5,12 | |
| Y | EP 1 001 534 A (YOZAN INC [JP]) 17 May 2000 (2000-05-17) * figures 3,5 * | 1-13 | |
| Y | EP 0 878 913 A (YOZAN INC [JP]) 18 November 1998 (1998-11-18) * page 9, lines 38-44; figures 12-14 * * page 10, lines 16-20 * | 1-13 | |
| Y | US 5 600 270 A (SHOU GUOLIANG [JP] ET AL) 4 February 1997 (1997-02-04) * column 9, line 44 - line 50; figure 15 * | 1-13 | |
| Y | SHUKLA R ET AL: "A low voltage rail to rail V-I conversion scheme for applications in current mode A/D converters" CIRCUITS AND SYSTEMS, 2004. ISCAS '04. PROCEEDINGS OF THE 2004 INTERNA TIONAL SYMPOSIUM ON VANCOUVER, BC, CANADA 23-26 MAY 2004, PISCATAWAY, NJ, USA,IEEE, US, 23 May 2004 (2004-05-23), pages I-916, XP010719476 ISBN: 978-0-7803-8251-0 * paragraph [0003] * | 1-13 | TECHNICAL FIELDS SEARCHED (IPC) H03M |
| Y | WO 89/07367 A (HUGHES AIRCRAFT CO [US]) 10 August 1989 (1989-08-10) * page 6, line 16 - line 27; figures 2,3 * | 1-13 | |

-/--

The present search report has been drawn up for all claims

| Place of search | Date of completion of the search | Examiner |
|---|---|---|
| Munich | 5 May 2008 | Müller, Uta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | RADHAKRISHNAN ET AL: "Low-Power 4-b 2.5 GSPS Pipleined Flash Analog to Digital converters in 0.13 um CMOS" IEEE, 2005, pages 287-292, XP002479044 * figure 2 * | 1-13 | |
| Y | SANROKU ET AL: "A CMOS 6-b, 200 MSample/s,3 V-Supply A/D Converter for a PRML Read Channel LSI" IEEE, 1996, pages 1831-1836, XP002479045 * paragraph [00II]; figures 2,3 * | 3,6 | |
| A | BALAKRISHNAN V G ET AL: "FAST/AREA EFFICIENT 8-BIT A/D AND D/A DESIGNS IN 0.8UM CMOS TECHNOLOGY USING LAYOUT GENERATORS" 14 July 1997 (1997-07-14), PROCEEDINGS OF THE IEEE 1997 NATIONAL AEROSPACE AND ELECTRONICS CONFERENCE. NAECON. DAYTON, JULY 14 - 17, 1997; [PROCEEDINGS OF THE IEEE NATIONAL AEROSPACE AND ELECTRONICS CONFERENCE. NAECON], NEW YORK, IEEE, US, PAGE(S) 372 - 377 , XP000873305 ISBN: 978-0-7803-3726-8 * paragraph [0002]; figures 5,6 * | 1-13 | TECHNICAL FIELDS SEARCHED (IPC) |

The present search report has been drawn up for all claims

| Place of search | Date of completion of the search | Examiner |
|---|---|---|
| Munich | 5 May 2008 | Müller, Uta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 962 428 A1

## ANNEX TO THE EUROPEAN SEARCH REPORT
## ON EUROPEAN PATENT APPLICATION NO.

EP 08 00 2687

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2008

| Patent document cited in search report | | Publication date | Patent family member(s) | | Publication date |
|---|---|---|---|---|---|
| EP 0541110 | A | 12-05-1993 | US | 5327131 A | 05-07-1994 |
| EP 1001534 | A | 17-05-2000 | CN | 1260660 A | 19-07-2000 |
| | | | KR | 20000028902 A | 25-05-2000 |
| | | | US | 6340942 B1 | 22-01-2002 |
| EP 0878913 | A | 18-11-1998 | DE | 69817443 D1 | 02-10-2003 |
| | | | DE | 69817443 T2 | 11-03-2004 |
| | | | US | 6281831 B1 | 28-08-2001 |
| US 5600270 | A | 04-02-1997 | NONE | | |
| WO 8907367 | A | 10-08-1989 | EP | 0353271 A1 | 07-02-1990 |
| | | | JP | 2503255 T | 04-10-1990 |
| | | | US | 4872010 A | 03-10-1989 |

EPO FORM P0459

For more details about this annex : see Official Journal of the European Patent Office, No. 12/82

16